# EUROPEAN PATENT SPECIFICATION

(11) **EP 2 806 464 B1**
(45) Date of publication and mention of the grant of the patent: **29.08.2018**
(21) Application number: 14169494.3
(22) Date of filing: 22.05.2014
(51) Int. Cl.: H01L 31/0216, H01L 31/0232

(54) **Colored solar cells and panels containing the same**
Gefärbte Solarzellen und Paneele damit
Cellules solaires colorées et panneaux les contenant

(30) Priority: 23.05.2013 TW 102118285
(43) Date of publication of application: 26.11.2014
(73) Proprietor: Sunshine PV Corp., Hukou Township, Hsinchu 303 (TW)
(72) Inventor: Kuo, Chun-Chiang, 303 Hsinchu County (TW); Li, Shenghan, 303 Hsinchu County (TW); Hou, William Weijen, 303 Hsinchu County (TW)
(74) Representative: J A Kemp

(56) References cited:
- CN-U- 201 956 359
- JP-A- 2003 197 937
- US-A1- 2010 037 948
- US-A1- 2012 060 891
- NAGEL H ET AL: "OPTIMISED ANTIREFLECTION COATINGS FOR PLANAR SILICON SOLAR CELLS USING REMOTE PECVD SILICON NITRIDE AND POROUS SILICON DIOXIDE", PROGRESS IN PHOTOVOLTAICS: RESEARCH AND APPLICATIONS, JOHN WILEY & SONS, LTD, vol. 7, no. 4, 1 July 1999 (1999-07-01), pages 245-260, XP000950137, ISSN: 1062-7995, DOI: 10.1002/(SICI)1099-159X(199907/08)7:4<245: :AID-PIP255>3.3.CO;2-V

## Description

### FIELD OF THE INVENTION

The present invention is related to a colored solar cell which exhibits both a high conversion efficiency and an optically desirable color. The present invention is also related to a panel containing said solar cell and the process for preparing the solar cell.

### BACKGROUND OF THE INVENTION

Due to the diminishing amount of fossil fuel and the environmental problems associated therewith, there is an urging need in the industry to find an efficient and environmentally friendly alternative energy source, and among various alternative energy sources, solar energy provides a potential solution to such crisis. A solar cell, which is also called a photovoltaic cell, is a device which converts the light energy from the sun into electricity via the photoelectric effect. A crystalline silicon solar cell is one of the prevalently used types of the solar cells. The design of a crystalline silicon solar cell is based on the formation of a p/n junction on the light incident plane and the formation of an anti-reflection layer on the junction to reduce the reflection of photons. In order to reduce the reflectivity and enhance the overall conversion efficiency, the appearance of the crystalline silicon solar cell or the panel is only limited to blue color. However, such monotonous color does not appear appealing to the public when the governments of many countries promote the installation of solar cells or solar cell panels on the roof or outer walls of buildings. A more pleasing color which is not only scientifically highly efficient but also aesthetically decorative to the buildings is needed, and development of solar cells or solar cell panels having various colors for fitting into the buildings or the environment has to be carried out.

Japanese patent publication JP 2003/197937 A discloses that solar cells exhibiting various colors may be achieved by disposing another anti-reflection layer on an existing anti-reflection layer on the surface of the solar cell and adjusting the thickness and reflectivity of said another anti-reflection layer. Nevertheless, the color of the solar cell is susceptible to the reflectivity and thickness of the anti-reflection layers, and the conversion efficiency of the solar cell will be directly affected by the selected materials of the anti-reflection layers. Due to the great amount of the potential species of materials and the extent of possible ranges of thickness, finding a suitable combination of the materials and thicknesses for such color adjusting measure is not only complicated but also time-consuming. In the prior art, the conversion efficiency of solar cells and the appearance of the solar cells other than conventional blue is often a trade-off, which holds the colored solar cells back from being commercialized successfully. Moreover, the color of a solar cell can still be changed during the encapsulation into a solar cell panel for further applications, for example, by the protection layer disposed thereon.

US 2010/037948 A1 discloses a solar cell comprising a color-modulating layer provided over the photoelectric conversion layer to modulate colorful appearance thereof, wherein an anti-reflection layer is laminated between the color-modulating layer and the photoelectric conversion layer.

Given the aforementioned problems left in the prior art, the objective of the present invention is to provide a colored solar cell which exhibits both a high conversion efficiency and an optically desirable color, and to provide an easy-to-produce colored solar cell and a panel containing the same to achieve the popularization of solar cells.

### SUMMARY OF THE INVENTION

In order to achieve the aforementioned objective, the present invention provides a colored solar cell comprising a photoelectric conversion substrate; at least one anti-reflection layer formed on the photoelectric conversion substrate; two or more transparent inorganic dielectric layers which are formed on the anti-reflection layer(s) wherein the two or more transparent inorganic dielectric layers comprise:
(a) at least one first transparent inorganic dielectric layer consisting of an oxide of titanium; and
(b) a second transparent inorganic dielectric layer selected from the group consisting of an aluminim doped zinc oxide, indium tin oxide, an oxide of zinc and a nitride of silicon and having a refractive index ranging from 1.5 to 2.0.

Preferably, in the colored solar cell of the invention, the photoelectric conversion substrate comprises a semiconductor material.

It is also preferred that the at least one anti-reflection layer comprises a nitride of silicon.

It is further preferred that the two or more transparent inorganic dielectric layers comprise at least one third transparent inorganic dielectric layer and at least one fourth transparent inorganic dielectric layer.

In one embodiment, the two or more transparent inorganic dielectric layers comprise one first transparent inorganic dielectric layer, one third transparent inorganic dielectric layer and one fourth transparent inorganic dielectric layer, and the first transparent inorganic dielectric layer lies between the third transparent inorganic dielectric layer and the fourth transparent inorganic dielectric layer.

In another embodiment, the two or more transparent inorganic dielectric layers comprise two first transparent inorganic dielectric layers, one third transparent inorganic dielectric layer and two fourth transparent inorganic dielectric layers, wherein the third transparent inorganic dielectric layer lies between the first transparent inorganic dielectric layers, and the first transparent inorganic dielectric layers lie between the third transparent inorganic dielectric layer and the two fourth transparent inorganic dielectric layers, wherein the two fourth transparent inorganic dielectric layers are the same or different.

Preferably, the third transparent inorganic dielectric layer and the fourth transparent inorganic dielectric layer(s) have a refractive index ranging from 1.3 to 2.0.

In another aspect, the present invention provides a solar cell panel, comprising a colored solar cell module formed from the colored solar cell according to the present invention; a protection layer disposed on the colored solar cell module; and a transparent glass plate disposed on the protection layer.

### BRIEF DESCRIPTION OF THE DRAWINGS

Fig. 1 shows the profile of a colored solar cell according to the present invention.
Fig. 2 shows the profile of a colored solar cell according to the present invention.
Fig. 3 shows the profile of a colored solar cell according to the present invention.
Fig. 4(a) shows the reflectivity of a red solar cell according to the present invention at various wavelengths.
Fig. 4(b) shows the reflectivity of a red solar cell according to the present invention at various wavelengths.
Fig. 5 shows the reflectivity of a green solar cell according to the present invention at various wavelengths.
Fig. 6 shows the reflectivity of a purple solar cell according to the present invention at various wavelengths.
Fig. 7 shows the reflectivity of a red solar cell according to the present invention at various wavelengths.

### DETAILED DESCRIPTION OF THE INVENTION

Throughout this application, the term "about" is used to indicate that the specific value measured by a person skilled in the art includes inherent but acceptable variation of errors from the method being employed to determine the value.

The structure of the prevalently used crystalline silicon solar cell mainly comprises (1) a photoelectric conversion substrate; and (2) an anti-reflection layer formed on the photoelectric conversion substrate, wherein the photoelectric conversion substrate comprises n-type doped and p-type doped semiconductor materials, and the semiconductor materials may be polycrystalline silicon materials or monocrystalline silicon materials. The n-type doped and p-type doped semiconductor materials are brought into contact with each other to form a photoelectric conversion substrate with a p/n junction. The anti-reflection layer may be a thin film formed from a nitride of silicon (SiNₓ).

The colored solar cell of the present invention comprises a photoelectric conversion substrate; at least one anti-reflection layer formed on the photoelectric conversion substrate; and two or more transparent inorganic dielectric layers which are formed on the anti-reflection layer, wherein the two or more transparent inorganic dielectric layers comprise at least one first transparent inorganic dielectric layer consisting of an oxide of titanium,
and the other one is a second transparent inorganic dielectric layer selected from the group consisting of an aluminium doped zinc oxide, indium tin oxide, an oxide of zinc and a nitride of silicon and having a refractive index ranging from 1.5 to 2.0.

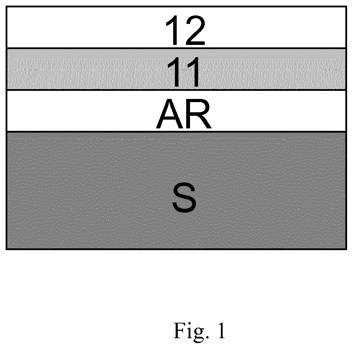

In reference to Fig. 1 showing the profile of a colored solar cell of the present invention, the colored solar cell comprises a photoelectric conversion substrate (S); an anti-reflection layer (AR), which is formed on the photoelectric conversion substrate; a first transparent inorganic dielectric layer (11) consisting of an oxide of titanium and a second transparent inorganic dielectric layer (12).

The colored solar cell may, for example, comprise a photoelectric conversion substrate; at least one anti-reflection layer formed on the photoelectric conversion substrate; at least three transparent inorganic dielectric layers formed above the anti-reflection layer and comprise at least one first transparent inorganic dielectric layer consisting of an oxide of titanium, at least one third transparent inorganic dielectric layer and at least one fourth transparent inorganic dielectric layer, wherein the first transparent inorganic dielectric layer lies between the third transparent inorganic dielectric layer and the fourth transparent inorganic dielectric layer.

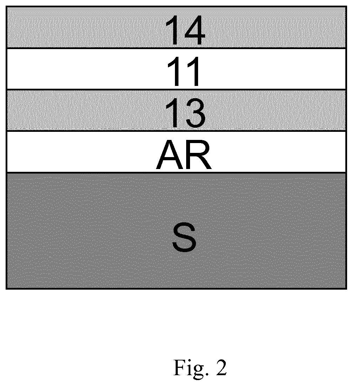

In reference to Fig. 2 showing the profile of a colored solar cell according to the present invention, the colored solar cell comprises a photoelectric conversion substrate (S); an anti-reflection layer (AR) formed on the photoelectric conversion substrate; and three transparent inorganic dielectric layers formed above the anti-reflection layer. The transparent inorganic dielectric layers comprise a first transparent inorganic dielectric layer (11) consisting of an oxide of titanium, a third transparent inorganic dielectric layer (13) and a fourth transparent inorganic dielectric layer (14). The first transparent inorganic dielectric layer (11) lies between the third transparent inorganic dielectric layer (13) and the fourth transparent inorganic dielectric layer (14).

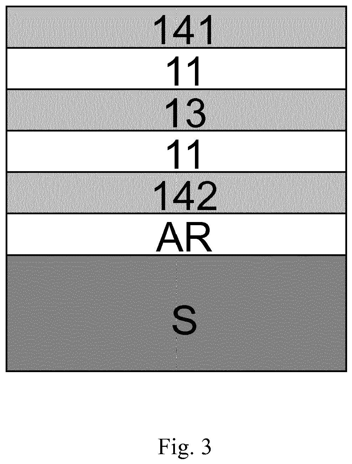

According to one another embodiment of the present invention, as shown in Fig. 3, the colored solar cell of the present invention comprises a photoelectric conversion substrate (S); an anti-reflection layer (AR) formed on the photoelectric conversion substrate; and multiple transparent inorganic dielectric layers formed above the anti-reflection layer. The multiple transparent inorganic dielectric layers comprise two first transparent inorganic dielectric layers (11) consisting of an oxide of titanium; one third transparent inorganic dielectric layer (13); and two fourth transparent inorganic dielectric layers (141 and 142) having different transparent inorganic dielectric layer materials. The third transparent inorganic dielectric layer (13) is sandwiched by the two first transparent inorganic dielectric layers, and the two first transparent inorganic dielectric layers are respectively sandwiched by the third transparent inorganic dielectric layer and the respective fourth transparent inorganic dielectric layers.

Any substrates known in the art as being suitable for solar cells may be used as the photoelectric conversion substrate of the present invention. The substrate may be a semiconductor material comprising n-type doped and p-type doped polycrystalline silicon substrates or monocrystalline silicon substrates.

Any materials known in the art as being suitable for the solar cells may be used in the present invention for forming the anti-reflection layer. The anti-reflection layer may comprise a single layered SiNₓ thin film formed from SiNₓ or two layered SiNₓ thin film with various ratios of nitrogen to silicon. The thin film may have a thickness from about 60 nm to about 100 nm.

The first transparent inorganic dielectric layer of the present invention consists of an oxide of titanium and has a refractive index ranging from about 2.2 to about 2.6 and a thickness ranging from about 50 nm to about 100 nm.

The second transparent inorganic dielectric layer of the present invention consists of a transparent inorganic dielectric material having a refractive index ranging from about 1.5 to about 2.0, and has a thickness from about 1 nm to 200 nm, preferably from about 100 nm to about 150 nm. The transparent inorganic dielectric material for the second transparent inorganic dielectric layer is selected from the group consisting of an aluminum doped zinc oxide, indium tin oxide, an oxide of zinc and a nitride of silicon.

The third and fourth transparent inorganic dielectric layers of the present invention consist of transparent inorganic dielectric layer materials having refractive indices from about 1.5 to about 2.0 and have thicknesses from about 1 nm to about 200 nm, preferably from about 30 nm to about 100 nm. More preferably, the third transparent inorganic dielectric layer has a thickness from about 50 nm to about 100 nm, and the fourth transparent inorganic dielectric layer has a thickness from about 30 nm to about 80 nm. The transparent inorganic dielectric materials for the third and fourth transparent inorganic dielectric layers are selected from the group consisting of an aluminum doped zinc oxide, indium tin oxide, an oxide of zinc, an oxide of silicon, and a nitride of silicon.

The transparent inorganic dielectric materials for the aforementioned second, third and fourth transparent inorganic dielectric layers may be the same or different.

According to the present invention, the anti-reflection layer and the transparent inorganic dielectric layer may be formed by any method known in the art such as DC magnetron sputtering, RF magnetron sputtering, evaporation, sputtering, chemical vapor deposition (CVD), coating or any other methods considered to be suitable and workable by a person skilled in the art.

According to one embodiment of the present invention, the colored solar cell of the present invention may be a red solar cell with a reflectivity spectrum within the visible light wavelength, which shows that the average reflectivity in the wavelength range of 600 nm to 800 nm is greater than the average reflectivity in the wavelength range of 400 nm to 600 nm by more than 35%. Further, even being encapsulated, the red solar cell of the present invention still shows a more than 25% greater average reflectivity in the wavelength range of 600 nm to 800 nm than that in the wavelength range of 400 nm to 600 nm.

The present invention further provides a panel including the aforementioned solar cell which is encapsulated by sequentially disposing a protection layer and a transparent layer on the colored solar cell. The protection layer suitable for the present invention may be any known encapsulation materials in the art such as ethylene vinyl acetate (EVA), polyvinyl butyral (PVB) or any other similar materials considered to be suitable and workable by a person skilled in the art. The protection layer protects the solar cell from the exposure to water and moisture. The transparent material used in the solar cell of the present invention may be any known and suitable materials in the art, such as glass.

Examples are provided below to further illustrate the present invention but not to limit the scope of the present invention.

### Examples

### Example 1

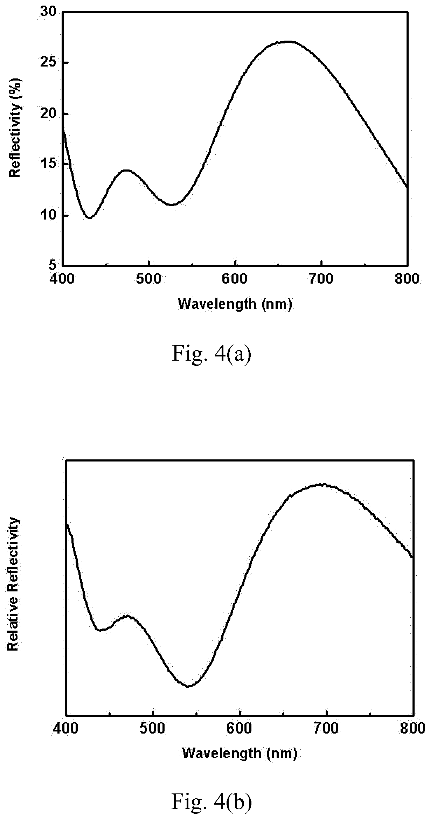

An anti-reflection layer comprising SiN_{1.1} was formed on a polycrystalline silicon photoelectric conversion substrate, and layers of an undoped zinc oxide (ZnO), titanium oxide (TiO₂) and indium tin oxide (ITO) were sequentially formed on the anti-reflection layer by RF magnetron sputtering to provide a red solar cell. The thicknesses and the refractive indices of the layers are listed in Table 1 below. The reflectivity of the solar cell and the solar cell panel encapsulated by EVA and a glass plate is tested at various wavelengths with a low angle incident light. The results are provided in Fig. 4(a) and Fig. 4(b).

**Table 1**

| Materials | Thickness | Refractive index |
|---|---|---|
| ITO | 200 nm | 1.8 |
| TiO₂ | 100 nm | 2.4 |
| ZnO | 50 nm | 2.0 |
| SiN_{1.1} | 80 nm | 2.1 |
| Polycystalline silicon (Si) | 0.2 mm | 3.5 |

The solar cell of Example 1 exhibits a red color due to the interferences resulting from the optical path differences produced when the incident light passes the multiple transparent inorganic dielectric layers disposed above the anti-reflection layer and reflects at each of the interfaces of the layers.

### Example 2

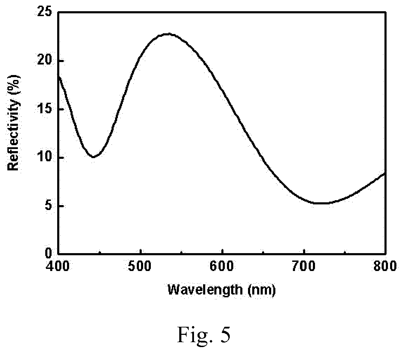

An anti-reflection layer comprising SiN_{1.1} was formed on a polycrystalline silicon photoelectric conversion substrate, and a layer of SiN_{1.3} was formed thereon by plasma-enhanced chemical vapor deposition. Layers of titanium oxide (TiO₂) and an aluminum-doped zinc oxide (AZO) were sequentially formed above the SiN_{1.3} layer by RF magnetron sputtering. A green solar cell was obtained. The thicknesses and the refractive indices of the layers are listed in Table 2 below. The reflectivity of the solar cell and the solar cell panel encapsulated by EVA and a glass plate was tested at various wavelengths with a low angle incident light. The results are provided in Fig. 5.

**Table 2**

| Materials | Thickness | Refractive index |
|---|---|---|
| AZO | 150 nm | 1.7 |
| TiO₂ | 50 nm | 2.4 |
| SiN_{1.3} | 30 nm | 1.9 |
| SiN_{1.1} | 80 nm | 2.1 |
| Polycrystalline silicon (Si) | 0.2 mm | 3.5 |

The solar cell of Example 2 exhibits a green color due to the interferences resulting from the optical path differences produced when the incident light passes the multiple transparent inorganic dielectric layers disposed above the anti-reflection layer and reflects at each of the interfaces of the layers.

### Example 3

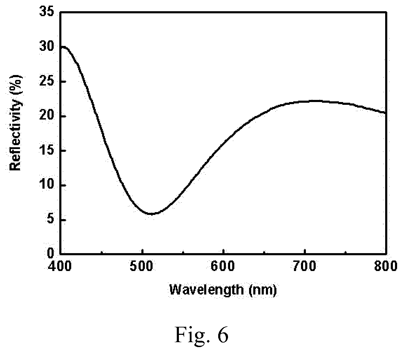

An anti-reflection layer comprising SiN_{1.1} was formed on a polycrystalline silicon photoelectric conversion substrate, and layers of titanium oxide (TiO₂) and an aluminum-doped zinc oxide (AZO) were sequentially formed above the anti-reflection layer by RF magnetron sputtering to provide a purple solar cell. The thicknesses and the refractive indices of the layers are listed in Table 3 below. The reflectivity of the solar cell and the solar cell panel encapsulated by EVA and a glass plate was tested at various wavelengths with a low angle incident light. The results are provided in Fig. 6.

**Table 3**

| Materials | Thickness | Refractive index |
|---|---|---|
| AZO | 100 nm | 1.7 |
| TiO₂ | 50 nm | 2.4 |
| SiN_{1.1} | 80 nm | 2.1 |
| Polycrystalline silicon (Si) | 0.2 mm | 3.5 |

The solar cell of Example 3 exhibits a purple color due to the interferences resulting from the optical path differences produced when the incident light passes the multiple transparent inorganic dielectric layers disposed above the anti-reflection layer and reflects at each of the interfaces of the layers.

### Example 4

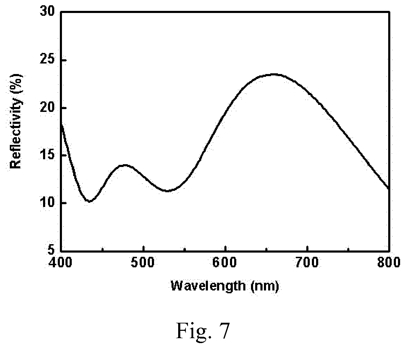

An anti-reflection layer comprising SiN_{1.1} is formed on a polycrystalline silicon photoelectric conversion substrate, and layers of ITO, titanium oxide (TiO₂), an aluminum-doped zinc oxide (AZO), titanium oxide (TiO₂) and zinc oxide (ZnO) were sequentially formed above the anti-reflection layer by RF magnetron sputtering to provide a red solar cell. The thicknesses and the refractive indices of the layers are listed in Table 4 below. The reflectivity of the solar cell and the solar cell panel encapsulated by EVA and a glass plate was tested at various wavelengths with a low angle incident light. The results are provided in Fig. 7.

**Table 4**

| Materials | Thickness | Refractive index |
|---|---|---|
| ZnO | 50 nm | 2.0 |
| TiO₂ | 80 nm | 2.4 |
| AZO | 100 nm | 1.7 |
| TiO₂ | 80 nm | 2.4 |
| ITO | 50 nm | 1.8 |
| SiN_{1.1} | 50 nm | 2.1 |
| Polycrystalline silicon (Si) | 0.2 mm | 3.5 |

The solar cell of Example 4 exhibits a red color due to the interferences resulting from the optical path differences produced when the incident light passes the multiple transparent inorganic dielectric layers disposed above the anti-reflection layer and reflects at each of the interfaces of the layers.

## Claims

1. A colored solar cell, comprising
a photoelectric conversion substrate;
at least one anti-reflection layer formed on the photoelectric conversion substrate; and
two or more transparent inorganic dielectric layers formed on the anti-reflection layer(s), **characterised in that** the two or more transparent inorganic dielectric layers comprise:
(a) at least one first transparent inorganic dielectric layer consisting of an oxide of titanium; and
(b) a second transparent inorganic dielectric layer selected from the group consisting of an aluminium doped zinc oxide, indium tin oxide, an oxide of zinc and a nitride of silicon and having a refractive index ranging from 1.5 to 2.0.

2. The colored solar cell according to Claim 1, wherein the photoelectric conversion substrate comprises a semiconductor material.

3. The colored solar cell according to Claim 1 or 2, wherein the at least one anti-reflection layer comprises a nitride of silicon.

4. The colored solar cell according to Claim 1, 2, or 3, wherein the two or more transparent inorganic dielectric layers comprise at least one third transparent inorganic dielectric layer and at least one fourth transparent inorganic dielectric layer.

5. The colored solar cell according to Claim 4, wherein the two or more transparent inorganic dielectric layers comprise one first transparent inorganic dielectric layer, one third transparent inorganic dielectric layer and one fourth transparent inorganic dielectric layer, and the first transparent inorganic dielectric layer lies between the third transparent inorganic dielectric layer and the fourth transparent inorganic dielectric layer.

6. The colored solar cell according to Claim 4, wherein the two or more transparent inorganic dielectric layers comprise two first transparent inorganic dielectric layers, one third transparent inorganic dielectric layer and two fourth transparent inorganic dielectric layers, wherein the third transparent inorganic dielectric layer lies between the first transparent inorganic dielectric layers, and the first transparent inorganic dielectric layers lie between the third transparent inorganic dielectric layer and the two fourth transparent inorganic dielectric layers, wherein the two fourth transparent inorganic dielectric layers are the same or different.

7. The colored solar cell according to any one of Claims 4 to 6, wherein the third transparent inorganic dielectric layer and the fourth transparent inorganic dielectric layer(s) have a refractive index ranging from 1.3 to 2.0.

8. A solar cell panel, comprising:
a colored solar cell according to any one of Claims 1 to 7;
a protection layer disposed on the colored solar cell; and
a transparent glass plate disposed on the protection layer.

## Patentansprüche

1. Gefärbte Solarzelle, umfassend:
ein fotoelektrisches Umwandlungssubstrat;
mindestens eine Anti-Reflexionsschicht, die auf dem fotelektrischen Umwandlungssubstrat gebildet ist; und
zwei oder mehrere transparente anorganische dielektrische Schichten, die auf der (den) Anti-Reflexionsschicht(en) gebildet sind,
**dadurch gekennzeichnet, dass**
die zwei oder die mehreren transparenten anorganischen dielektrischen Schichten Folgendes umfassen:
(a) mindestens eine erste transparente anorganische dielektrische Schicht bestehend aus einem Oxid von Titan; und
(b) eine zweite transparente anorganische dielektrische Schicht, die ausgewählt ist aus der Gruppe bestehend aus einem Aluminium-dotierten Zinkoxid, Indiumzinnoxid, einem Oxid von Zink und einem Nitrid von Silicium und die einen Brechungsindex von 1,5 bis 2,0 hat.

2. Gefärbte Solarzelle nach Anspruch 1, wobei das fotoelektrische Umwandlungssubstrat ein Halbleitermaterial umfasst.

3. Gefärbte Solarzelle nach Anspruch 1 oder 2, wobei die mindestens eine Anti-Reflexionsschicht ein Nitrid von Silicium umfasst.

4. Gefärbte Solarzelle nach Anspruch 1, 2 oder 3, wobei die zwei oder die mehreren transparenten anorganischen dielektrischen Schichten mindestens eine dritte transparente anorganische dielektrische Schicht und mindestens eine vierte transparente anorganische dielektrische Schicht umfassen.

5. Gefärbte Solarzelle nach Anspruch 4, wobei die zwei oder die mehreren transparenten anorganischen dielektrischen Schichten eine erste transparente anorganische dielektrische Schicht, eine dritte transparente anorganische dielektrische Schicht und eine vierte transparente anorganische dielektrische Schicht umfassen und die erste transparente anorganische dielektrische Schicht zwischen der dritten transparenten anorganischen dielektrischen Schicht und der vierten transparenten anorganischen dielektrischen Schicht liegt.

6. Gefärbte Solarzelle nach Anspruch 4, wobei die zwei oder die mehreren transparenten anorganischen dielektrischen Schichten zwei erste transparente anorganische dielektrische Schichten, eine dritte transparente anorganische dielektrische Schicht und zwei vierte transparente anorganische dielektrische Schichten umfassen, wobei die dritte transparente anorganische dielektrische Schicht zwischen den ersten transparenten anorganischen dielektrischen Schichten liegt und die ersten transparenten anorganischen dielektrischen Schichten zwischen der dritten transparenten anorganischen dielektischen Schicht und den zwei vierten transparenten anorganischen dielektrischen Schichten liegen, wobei die zwei vierten transparenten anorganischen dielektrischen Schichten gleich oder unterschiedlich sind.

7. Gefärbte Solarzelle nach einem der Ansprüche 4 bis 6, wobei die dritte transparente anorganische dielektrische Schicht und die vierte(n) transparente(n) anorganische(n) dielektrische(n) Schicht(en) einen Brechungsindex im Bereich von 1,3 bis 2,0 haben.

8. Solarzellenpaneel, umfassend:
eine gefärbte Solarzelle nach einem der Ansprüche 1 bis 7;
eine Schutzschicht, die auf der gefärbten Solarzelle angeordnet ist; und
eine transparente Glasplatte, die auf der Schutzschicht angeordnet ist.

## Revendications

1. Cellule solaire colorée, comprenant
un substrat de conversion photoélectrique ;
au moins une couche antireflet formée sur le substrat de conversion photoélectrique ; et
au moins deux couches diélectriques inorganiques transparentes formées sur la/les couche(s) antireflet,
**caractérisée en ce que**
les au moins deux couches diélectriques inorganiques transparentes comprennent :
(a) au moins une première couche diélectrique inorganique transparente constituée d'un oxyde de titane ; et
(b) une deuxième couche diélectrique inorganique transparente choisie dans le groupe constitué par un oxyde de zinc dopé à l'aluminium, un oxyde d'indium-étain, un oxyde de zinc et un nitrure de silicium et présentant un indice de réfraction allant de 1,5 à 2,0.

2. Cellule solaire colorée selon la revendication 1, dans laquelle le substrat de conversion photoélectrique comprend un matériau semi-conducteur.

3. Cellule solaire colorée selon la revendication 1 ou 2, dans laquelle l'au moins une couche antireflet comprend un nitrure de silicium.

4. Cellule solaire colorée selon la revendication 1, 2 ou 3, dans laquelle les au moins deux couches diélectriques inorganiques transparentes comprennent au moins une troisième couche diélectrique inorganique transparente et au moins une quatrième couche diélectrique inorganique transparente.

5. Cellule solaire colorée selon la revendication 4, dans laquelle les au moins deux couches diélectriques inorganiques transparentes comprennent une première couche diélectrique inorganique transparente, une troisième couche diélectrique inorganique transparente et une quatrième couche diélectrique inorganique transparente, et la première couche diélectrique inorganique transparente est située entre la troisième couche diélectrique inorganique transparente et la quatrième couche diélectrique inorganique transparente.

6. Cellule solaire colorée selon la revendication 4, dans laquelle les au moins deux couches diélectriques inorganiques transparentes comprennent deux premières couches diélectriques inorganiques transparentes, une troisième couche diélectrique inorganique transparente et deux quatrièmes couches diélectriques inorganiques transparentes, la troisième couche diélectrique inorganique transparente étant située entre les premières couches diélectriques inorganiques transparentes, et les premières couches diélectriques inorganiques transparentes étant situées entre la troisième couche diélectrique inorganique transparente et les deux quatrièmes couches diélectriques inorganiques transparentes, les deux quatrièmes couches diélectriques inorganiques transparentes étant identiques ou différentes.

7. Cellule solaire colorée selon l'une quelconque des revendications 4 à 6, dans laquelle la troisième couche diélectrique inorganique transparente et la/les quatrième(s) couche(s) diélectrique(s) inorganique(s) transparente(s) présentent un indice de réfraction allant de 1,3 à 2,0.

8. Panneau à cellules solaires, comprenant :
une cellule solaire colorée selon l'une quelconque des revendications 1 à 7 ;
une couche de protection disposée sur la cellule solaire colorée ; et
une plaque de verre transparente disposée sur la couche de protection.
